# EUROPEAN PATENT APPLICATION

(11) **EP 1 860 505 A1**
(43) Date of publication of application: **28.11.2007**
(21) Application number: 07016082.5
(22) Date of filing: 06.12.2006
(51) Int. Cl.: G03F 7/20

(54) **Lithographic apparatus and device manufacturing method using multiple exposures and multiple exposure types**

(30) Priority: 20.12.2005 US 311643
(62) Divisional of application: 06256226.9
(71) Applicant: ASML Netherlands B.V., 5504 DR Veldhoven (NL)
(72) Inventor: Troost, Kars, Zeger, 5583 XP Waalre (NL); Baselmans, Johannes, Jacobus, Matheus, 5688 GG Oirschot (NL); Bleeker, Arno, Jan, 5563 CE Westerhoven (NL); Greeneich, James Sherwood, Prescott AZ 86305 (US)
(74) Representative: Leeming, John Gerard

(57) **Abstract**

A lithographic apparatus and method in which a relatively high resolution exposure, for example of a repeating pattern, is trimmed using a relatively low resolution exposure. According, a compromise between provision of a high resolution pattern and flexibility in the pattern to be formed is provided.

## Description

### BACKGROUND

### Field of the Invention

The present invention relates to a lithographic apparatus and device manufacturing method.

### Related Art

A lithographic apparatus is a machine that applies a desired pattern onto a substrate or part of a substrate. A lithographic apparatus can be used, for example, in the manufacture of flat panel displays, integrated circuits (ICs) and other devices involving fine structures. In a conventional apparatus, a patterning device, which can be referred to as a mask or a reticle, can be used to generate a circuit pattern corresponding to an individual layer of a flat panel display (or other device). This pattern can be transferred onto all or part of the substrate (e.g., a glass plate), by imaging onto a layer of radiation-sensitive material (resist) provided on the substrate.

Instead of a circuit pattern, the patterning means can be used to generate other patterns, for example a color filter pattern or a matrix of dots. Instead of a mask, the patterning device can comprise a patterning array that comprises an array of individually controllable elements. The pattern can be changed more quickly and for less cost in such a system compared to a mask-based system.

A flat panel display substrate is typically rectangular in shape. Lithographic apparatus designed to expose a substrate of this type can provide an exposure region that covers a full width of the rectangular substrate, or covers a portion of the width (for example half of the width). The substrate can be scanned underneath the exposure region, while the mask or reticle is synchronously scanned through a beam. In this way, the pattern is transferred to the substrate. If the exposure region covers the full width of the substrate then exposure can be completed with a single scan. If the exposure region covers, for example, half of the width of the substrate, then the substrate can be moved transversely after the first scan, and a further scan is typically performed to expose the remainder of the substrate.

In order to generate devices with ever smaller features, with ever more customization within devices and in ever more cost-effective ways, there is a continuing drive to improve photographic methods. However, these three goals often interfere. For example, a new technique can permit the provision of smaller features but increases the processes time necessary to form the device, thereby increasing the cost of the device. Similarly, provision of processes that allow greater flexibility in forming the devices can require a compromise in the size of the features that can be formed and/or increase the cost of forming the device.

What is needed is a lithographic apparatus and method that provides a suitable compromise between the desire to form smaller features, the desire to provide a flexible lithographic system, and the desire to form devices for a minimum cost.

### SUMMARY

In one embodiment of the present invention, there is provided a lithographic apparatus comprising at least one array of individually controllable elements. The at least one array of individually controllable elements expose a pattern on a substrate by a combination of one or more exposures of a first type and one or more exposures of a second type. For an exposure of the first type, a beam of radiation is modulated by the at least one array of individually controllable elements and projected onto the substrate, such that a repeating pattern is projected onto the substrate. For an exposure of the second type, a beam of radiation is modulated by at least one of the at least one array of individually controllable elements and projected onto the substrate, such that the size of a portion of the exposure on the substrate corresponding to an individually controllable element is larger for an exposure of the second type than for an exposure of the first type.

In another embodiment of the present invention, there is provided a device manufacturing method, comprising the following steps. Exposing a pattern on a substrate by the combination of one or more exposures of a first type and one or more exposures of a second type. For an exposure of the first type, a beam of radiation is modulated by an array of individually controllable elements and projected onto the substrate, such that a repeating pattern is exposed on the substrate. For an exposure of the second type, a beam of radiation is modulated by an array of individually controllable elements and projected onto the substrate, such that the size of a portion of the exposure on the substrate corresponding to an individually controllable element is larger for an exposure of the second type than for an exposure of the first type.

In a further embodiment of the present invention, there is provided a lithographic apparatus comprising: a support, a patterning device, an array of individually controllable elements, and a projection system. The support supports the patterning device. The patterning device modulates a beam of radiation to form a first modulated beam of radiation. The array of individually controllable elements modulate the first modulated beam of radiation to form a second modulated beam of radiation. The projection system projects the second modulated beam of radiation onto a substrate.

In yet another embodiment of the present invention, there is provided a device manufacturing method comprising the following steps. Using a patterning device to modulate a beam of radiation to form a first modulated beam of radiation. Using an array of individually controllable elements to modulate the first modulated beam of radiation to form a second modulated beam of radiation. Projecting the second modulated beam of radiation onto a substrate.

In a still further embodiment of the present invention, there is provided an array of individually controllable elements that modulate a beam of radiation according to a repeating pattern. The array receives a control signal indicating that the repeating pattern is to be provided and, in response, to set the individually controllable elements to the states necessary to modulate a beam of radiation according to the repeating pattern.

In a yet further embodiment of the present invention, there is provided a device manufacturing method comprising the following steps. Providing a control signal to an array of individually controllable elements indicating that the array of individually controllable elements is to be set to modulate a beam of radiation according to a repeating pattern. The array of individually controllable elements being configured to receive the control signal and set the individually controllable elements to the states necessary to modulate a beam of radiation according to the pattern. Modulating a beam of radiation using the array of individually controllable elements.

. In another further embodiment of the present invention, there is provided a lithographic apparatus comprising an array of individually controllable elements configured to modulate a beam of radiation; and a projection system configured to project the modulated beam of radiation onto a substrate; wherein the individually controllable elements include patterning surfaces, constructed to impart a given pattern to the portion of the modulated beam of radiation corresponding to the individually controllable elements.

In a still further embodiment of the present invention, there is provided an array of individually controllable elements that modulate a beam of radiation. The individually controllable elements include patterning surfaces, constructed to impart a given pattern to a portion of the modulated beam of radiation corresponding to the individually controllable element.

In another embodiment of the present invention, there is provided a device manufacturing method comprising the following steps. Modulating a beam of radiation using an array of individually controllable elements and projecting the modulated beam of radiation onto a substrate. The individually controllable elements include patterning surfaces that impart a given pattern to the portion of the modulated beam of radiation corresponding to the individually controllable element.

Further embodiments, features, and advantages of the present inventions, as well as the structure and operation of the various embodiments of the present invention, are described in detail below with reference to the accompanying drawings.

### BRIEF DESCRIPTION OF THE DRAWINGS/FIGURES

The accompanying drawings, which are incorporated herein and form a part of the specification, illustrate one or more embodiments of the present invention and, together with the description, further serve to explain the principles of the invention and to enable a person skilled in the pertinent art to make and use the invention.

Figures 1 and 2 depict lithographic apparatus, according to various embodiments of the present invention.

Figure 3 depicts a mode of transferring a pattern to a substrate according to an embodiment of the invention as show in Figure 2.

Figure 4 depicts an arrangement of optical engines, according to one embodiment of the present invention.

Figure 5 depicts a lithographic apparatus, according to a first embodiment of the present invention.

Figure 6 depicts a lithographic apparatus, according to a second embodiment of the present invention.

Figure 7 depicts a lithographic apparatus, according to a third embodiment of the present invention.

Figure 8 depicts a lithographic apparatus, according to a fourth embodiment of the present invention.

Figures 9a, 9b and 9c depict, respectively, an exposure of a first type, an exposure of a second type and the result of combining an exposure of the first type and exposure of the second type, as performed by a lithographic apparatus of one of the first four embodiments of the present invention.

Figures 10a, 10b and 10c depict alternative exposures of a first type that can be formed by a lithographic apparatus of any one of the first four embodiments.

Figure 11 depicts a lithographic apparatus, according to a fifth embodiment of the present invention.

Figure 12 depicts an array of individually controllable elements that can be used in the lithographic apparatus of any of the above embodiments of the,present invention.

Figure 13 depicts an alternative array of individually controllable elements that can be used in the lithographic apparatus of any of the above embodiments of the present invention.

Figures 14a and 14b depict a lithographic apparatus, according to a sixth embodiment of the present invention in first and second operating conditions, respectively.

Figures 15a and 15b depict, in greater detail, an array of individually controllable elements that can be used with the lithographic apparatus of the sixth embodiment of the present invention.

The present invention will now be described with reference to the accompanying drawings. In the drawings, like reference numbers can indicate identical or functionally similar elements. Additionally, the left-most digit(s) of a reference number can identify the drawing in which the reference number first appears.

### DETAILED DESCRIPTION

While specific configurations and arrangements are discussed, it should be understood that this is done for illustrative purposes only. A person skilled in the pertinent art will recognize that other configurations and arrangements can be used without departing from the spirit and scope of the present invention. It will be apparent to a person skilled in the pertinent art that this invention can also be employed in a variety of other applications.

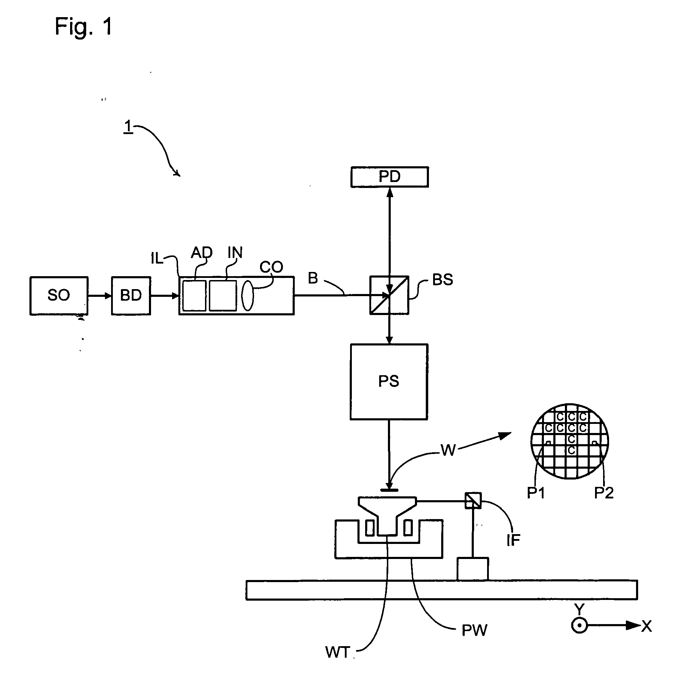

Figure 1 schematically depicts the lithographic apparatus of one embodiment of the invention. The apparatus comprises an illumination system IL, a patterning device PD, a substrate table WT, and a projection system PS. The illumination system (illuminator) IL is configured to condition a radiation beam B (e.g., UV radiation).

The patterning device PD (e.g., a reticle or mask or an array of individually controllable elements) modulates the beam. In general, the position of the array of individually controllable elements will be fixed relative to the projection system PS. However, it can instead be connected to a positioner configured to accurately position the array of individually controllable elements in accordance with certain parameters.

The substrate table WT is constructed to support a substrate (e.g., a resist-coated substrate) W and connected to a positioner PW configured to accurately position the substrate in accordance with certain parameters.

The projection system (e.g., a refractive projection lens system) PS is configured to project the beam of radiation modulated by the array of individually controllable elements onto a target portion C (e.g., comprising one or more dies) of the substrate W.

The illumination system can include various types of optical components, such as refractive, reflective, magnetic, electromagnetic, electrostatic or other types of optical components, or any combination thereof, for directing, shaping, or controlling radiation.

The term "patterning device" or "contrast device" used herein should be broadly interpreted as referring to any device that can be used to modulate the cross-section of a radiation beam, such as to create a pattern in a target portion of the substrate. The devices can be either static patterning devices (e.g., masks or reticles) or dynamic (e.g., arrays of programmable elements) patterning devices. For brevity, most of the description will be in terms of a dynamic patterning device, however it is to be appreciated that a static pattern device can also be used without departing from the scope of the present invention.

It should be noted that the pattern imparted to the radiation beam may not exactly correspond to the desired pattern in the target portion of the substrate, for example if the pattern includes phase-shifting features or so called assist features. Similarly, the pattern eventually generated on the substrate may not correspond to the pattern formed at any one instant on the array of individually controllable elements. This can be the case in an arrangement in which the eventual pattern formed on each part of the substrate is built up over a given period of time or a given number of exposures during which the pattern on the array of individually controllable elements and/or the relative position of the substrate changes.

Generally, the pattern created on the target portion of the substrate will correspond to a particular functional layer in a device being created in the target portion, such as an integrated circuit or a flat panel display (e.g., a color filter layer in a flat panel display or a thin film transistor layer in a flat panel display). Examples of such patterning devices include, e.g., reticles, programmable mirror arrays, laser diode arrays, light emitting diode arrays, grating light valves, and LCD arrays.

Patterning devices whose pattern is programmable with the aid of electronic means (e.g., a computer), such as patterning devices comprising a plurality of programmable elements (e.g., all the devices mentioned in the previous sentence except for the reticle), are collectively referred to herein as "contrast devices." In one example, the patterning device comprises at least 10 programmable elements, e.g., at least 100, at least 1000, at least 10000, at least 100000, at least 1000000, or at least 10000000 programmable elements.

A programmable mirror array can comprise a matrix-addressable surface having a viscoelastic control layer and a reflective surface. The basic principle behind such an apparatus is that, e.g., addressed areas of the reflective surface reflect incident light as diffracted light, whereas unaddressed areas reflect incident light as undiffracted light. Using an appropriate spatial filter, the undiffracted light can be filtered out of the reflected beam, leaving only the diffracted light to reach the substrate. In this manner, the beam becomes patterned according to the addressing pattern of the matrix-addressable surface.

It will be appreciated that, as an alternative, the filter can filter out the diffracted light, leaving the undiffracted light to reach the substrate.

An array of diffractive optical MEMS devices (micro-electromechanical system devices) can also be used in a corresponding manner. In one example, a diffractive optical MEMS device is comprised of a plurality of reflective ribbons that can be deformed relative to one another to form a grating that reflects incident light as diffracted light.

A further alternative example of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors reflect an incoming radiation beam in a different direction to unaddressed mirrors; in this manner, the reflected beam can be patterned according to the addressing pattern of the matrix-addressable mirrors. The required matrix addressing can be performed using suitable electronic means.

Another example PD is a programmable LCD array.

The lithographic apparatus can comprise one or more contrast devices. For example, it can have a plurality of arrays of individually controllable elements, each controlled independently of each other. In such an arrangement, some or all of the arrays of individually controllable elements can have at least one of a common illumination system (or part of an illumination system), a common support structure for the arrays of individually controllable elements, and/or a common projection system (or part of the projection system).

In an example, such as the embodiment depicted in Figure 1, the substrate W has a substantially circular shape, optionally with a notch and/or a flattened edge along part of its perimeter. In an example, the substrate has a polygonal shape, e.g., a rectangular shape.

In example where the substrate has a substantially circular shape include examples where the substrate has a diameter of at least 25mm, for instance at least 50mm, at least 75mm, at least 100mm, at least 125mm, at least 150mm, at least 175mm, at least 200mm, at least 250mm, or at least 300mm. In an embodiment, the substrate has a diameter of at most 500mm, at most 400mm, at most 350mm, at most 300mm, at most 250mm, at most 200mm, at most 150mm, at most 100mm, or at most 75mm.

In examples where the substrate is polygonal, e.g., rectangular, include examples where at least one side, e.g., at least 2 sides or at least 3 sides, of the substrate has a length of at least 5cm, e.g., at least 25cm, at least 50cm, at least 100cm, at least 150cm, at least 200cm, or at least 250cm.

In one example, at least one side of the substrate has a length of at most 1000cm, e.g., at most 750cm, at most 500cm, at most 350cm, at most 250cm, at most 150cm, or at most 75cm.

In one example, the substrate W is a wafer, for instance a semiconductor wafer. In one example, the wafer material is selected from the group consisting of Si, SiGe, SiGeC, SiC, Ge, GaAs, InP, and InAs. In one example, the wafer is a III/V compound semiconductor wafer. In one example, the wafer is a silicon wafer. In an embodiment, the substrate is a ceramic substrate. In one example, the substrate is a glass substrate. In one example, the substrate is a plastic substrate. In one example, the substrate is transparent (for the naked human eye). In one example, the substrate is colored. In one example, the substrate is absent a color.

The thickness of the substrate can vary and, to an extent, can depend, e.g., on the substrate material and/or the substrate dimensions. In one example, the thickness is at least 50µm, e.g., at least 100µm, at least 200µm, at least 300µm, at least 400µm, at least 500µm, or at least 600µm. In one example, the thickness of the substrate is at most 5000µm, e.g., at most 3500µm, at most 2500µm, at most 1750µm, at most 1250µm, at most 1000µm, at most 800µm, at most 600µm, at most 500µm, at most 400µm, or at most 300µm.

The substrate referred to herein can be processed, before or after exposure, in for example a track (a tool that typically applies a layer of resist to a substrate and develops the exposed resist), a metrology tool, and/or an inspection tool. In one example, a resist layer is provided on the substrate.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein can be considered as synonymous with the more general term "projection system."

The projection system can image the pattern on the array of individually controllable elements, such that the pattern is coherently formed on the substrate. Alternatively, the projection system can image secondary sources for which the elements of the array of individually controllable elements act as shutters. In this respect, the projection system can comprise an array of focusing elements such as a micro lens array (known as an MLA) or a Fresnel lens array, e.g., to form the secondary sources and to image spots onto the substrate. In one example, the array of focusing elements (e.g., MLA) comprises at least 10 focus elements, e.g., at least 100 focus elements, at least 1000 focus elements, at least 10000 focus elements, at least 100000 focus elements, or at least 1000000 focus elements. In one example, the number of individually controllable elements in the patterning device is equal to or greater than the number of focusing elements in the array of focusing elements. In one example, one or more (e.g., 1000 or more, the majority, or about each) of the focusing elements in the array of focusing elements can be optically associated with one or more of the individually controllable elements in the array of individually controllable elements, e.g., with 2 or more of the individually controllable elements in the array of individually controllable elements, such as 3 or more, 5 or more, 10 or more, 20 or more, 25 or more, 35 or more, or 50 or more. In one example, the MLA is movable (e.g., with the use of actuators) at least in the direction to and away from the substrate, e.g., with the use of one or more actuators. Being able to move the MLA to and away from the substrate allows, e.g., for focus adjustment without having to move the substrate.

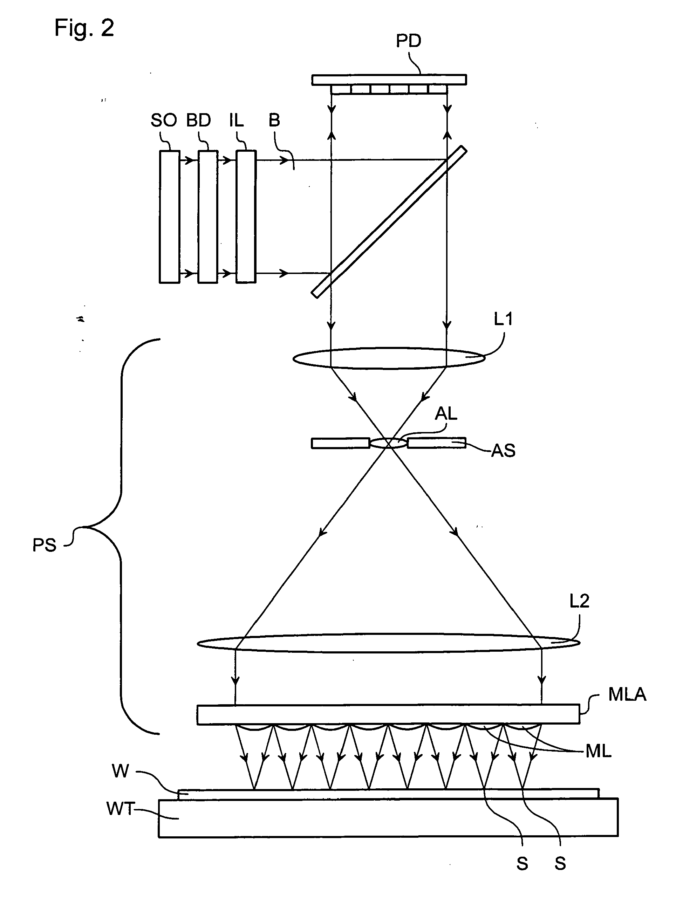

As herein depicted in Figures 1 and 2, the apparatus is of a reflective type (e.g., employing a reflective array of individually controllable elements). Alternatively, the apparatus can be of a transmissive type (e.g., employing a transmissive array of individually controllable elements).

The lithographic apparatus can be of a type having two (dual stage) or more substrate tables. In such "multiple stage" machines, the additional tables can be used in parallel, or preparatory steps can be carried out on one or more tables while one or more other tables are being used for exposure.

The lithographic apparatus can also be of a type wherein at least a portion of the substrate can be covered by an "immersion liquid" having a relatively high refractive index, e.g., water, so as to fill a space between the projection system and the substrate. An immersion liquid can also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring again to Figure 1, the illuminator IL receives a radiation beam from a radiation source SO. In one example, the radiation source provides radiation having a wavelength of at least 5 nm, e.g., at least 10nm, at least 50nm, at least 100nm, at least 150nm, at least 175nm, at least 200nm, at least 250nm, at least 275 nm, at least 300nm, at least 325nm, at least 350nm, or at least 360nm. In one example, the radiation provided by radiation source SO has a wavelength of at most 450nm, e.g., at most 425nm, at most 375nm, at most 360nm, at most 325nm, at most 275nm, at most 250nm, at most 225nm, at most 200nm, or at most 175nm. In one example, the radiation has a wavelength including 436nm, 405nm, 365nm, 355nm, 248nm, 193 nm, 157nm, and/or 126 nm. In one example, the radiation includes a wavelength of around 365nm or around 355nm. In one example, the radiation includes a broad band of wavelengths, for example encompassing 365, 405, and 436nm. A 355nm laser source could be used. The source and the lithographic apparatus can be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source can be an integral part of the lithographic apparatus, for example when the source is a mercury lamp. The source SO and the illuminator IL, together with the beam delivery system BD if required, can be referred to as a radiation system.

The illuminator IL, can comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL can comprise various other components, such as an integrator IN and a condenser CO. The illuminator can be used to condition the radiation beam to have a desired uniformity and intensity distribution in its cross-section. The illuminator IL, or an additional component associated with it, can also be arranged to divide the radiation beam into a plurality of sub-beams that can, for example, each be associated with one or a plurality of the individually controllable elements of the array of individually controllable elements. A two-dimensional diffraction grating can, for example, be used to divide the radiation beam into sub-beams. In the present description, the terms "beam of radiation" and "radiation beam" encompass, but are not limited to, the situation in which the beam is comprised of a plurality of such sub-beams of radiation.

The radiation beam B is incident on the patterning device PD (e.g., an array of individually controllable elements) and is modulated by the patterning device. Having been reflected by the patterning device PD, the radiation beam B passes through the projection system PS, which focuses the beam onto a target portion C of the substrate W. With the aid of the positioner PW and position sensor IF2 (e.g., an interferometric device, linear encoder, capacitive sensor, or the like), the substrate table WT can be moved accurately, e.g., so as to position different target portions C in the path of the radiation beam B. Where used, the positioning means for the array of individually controllable elements can be used to correct accurately the position of the patterning device PD with respect to the path of the beam B, e.g., during a scan.

In one example, movement of the substrate table WT is realized with the aid of a long-stroke module (course positioning) and a short-stroke module (fine positioning), which are not explicitly depicted in Figure 1. In one example, the apparatus is absent at least a short stroke module for moving substrate table WT. A similar system can also be used to position the array of individually controllable elements. It will be appreciated that the beam B can alternatively/additionally be moveable, while the object table and/or the array of individually controllable elements can have a fixed position to provide the required relative movement. Such an arrangement can assist in limiting the size of the apparatus. As a further alternative, which can, e.g., be applicable in the manufacture of flat panel displays, the position of the substrate table WT and,the projection system PS can be fixed and the substrate W can be arranged to be moved relative to the substrate table WT. For example, the substrate table WT can be provided with a system for scanning the substrate W across it at a substantially constant velocity.

As shown in Figure 1, the beam of radiation B can be directed to the patterning device PD by means of a beam splitter BS configured such that the radiation is initially reflected by the beam splitter and directed to the patterning device PD. It should be realized that the beam of radiation B can also be directed at the patterning device without the use of a beam splitter. In one example, the beam of radiation is directed at the patterning device at an angle between 0 and 90°, e.g., between 5 and 85°, between 15 and 75°, between 25 and 65°, or between 35 and 55° (the embodiment shown in Figure 1 is at a 90° angle). The patterning device PD modulates the beam of radiation B and reflects it back to the beam splitter BS which transmits the modulated beam to the projection system PS. It will be appreciated, however, that alternative arrangements can be used to direct the beam of radiation B to the patterning device PD and subsequently to the projection system PS. In particular, an arrangement such as is shown in Figure 1 may not be required if a transmissive patterning device is used.

The depicted apparatus can be used in several modes:

1. In step mode, the array of individually controllable elements and the substrate are kept essentially stationary, while an entire pattern imparted to the radiation beam is projected onto a target portion C at one go (i.e., a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the array of individually controllable elements and the substrate are scanned synchronously while a pattern imparted to the radiation beam is projected onto a target portion C (i.e., a single dynamic exposure). The velocity and direction of the substrate relative to the array of individually controllable elements can be determined by the (de-) magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In pulse mode, the array of individually controllable elements is kept essentially stationary and the entire pattern is projected onto a target portion C of the substrate W using a pulsed radiation source. The substrate table WT is moved with an essentially constant speed such that the beam B is caused to scan a line across the substrate W. The pattern on the array of individually controllable elements is updated as required between pulses of the radiation system and the pulses are timed such that successive target portions C are exposed at the required locations on the substrate W. Consequently, the beam B can scan across the substrate W to expose the complete pattern for a strip of the substrate. The process is repeated until the complete substrate W has been exposed line by line.

4. In continuous scan mode, essentially the same as pulse mode except that the substrate W is scanned relative to the modulated beam of radiation B at a substantially constant speed and the pattern on the array of individually controllable elements is updated as the beam B scans across the substrate W and exposes it. A substantially constant radiation source or a pulsed radiation source, synchronized to the updating of the pattern on the array of individually controllable elements; can be used.

5. In pixel grid imaging mode, which can be performed using the lithographic apparatus of Figure 2, the pattern formed on substrate W is realized by subsequent exposure of spots formed by a spot generator that are directed onto patterning device PD. The exposed spots have substantially the same shape. On substrate W the spots are printed in substantially a grid. In one example, the spot size is larger than a pitch of a printed pixel grid, but much smaller than the exposure spot grid. By varying intensity of the spots printed, a pattern is realized. In between the exposure flashes the intensity distribution over the spots is varied.

Combinations and/or variations on the above described modes of use or entirely different modes of use can also be employed.

In lithography, a pattern is exposed on a layer of resist on the substrate. The resist is then developed. Subsequently, additional processing steps are performed on the substrate. The effect of these subsequent processing steps on each portion of the substrate depends on the exposure of the resist. In particular, the processes are tuned such that portions of the substrate that receive a radiation dose above a given dose threshold respond differently to portions of the substrate that receive a radiation dose below the dose threshold. For example, in an etching process, areas of the substrate that receive a radiation dose above the threshold are protected from etching by a layer of developed resist. However, in the post-exposure development, the portions of the resist that receive a radiation dose below the threshold are removed and therefore those areas are not protected from etching. Accordingly, a desired pattern can be etched. In particular, the individually controllable elements in the patterning device are set such that the radiation that is transmitted to an area on the substrate within a pattern feature is at a sufficiently high intensity that the area receives a dose of radiation above the dose threshold during the exposure. The remaining areas on the substrate receive a radiation dose below the dose threshold by setting the corresponding individually controllable elements to provide a zero or significantly lower radiation intensity.

In practice, the radiation dose at the edges of a pattern feature does not abruptly change from a given maximum dose to zero dose even if the individually controllable elements are set to provide the maximum radiation intensity on one side of the feature boundary and the minimum radiation intensity on the other side. Instead, due to diffractive effects, the level of the radiation dose drops off across a transition zone. The position of the boundary of the pattern feature ultimately formed by the developed resist is determined by the position at which the received dose drops below the radiation dose threshold. The profile of the drop-off of radiation dose across the transition zone, and hence the precise position of the pattern feature boundary, can be controlled more precisely by setting the individually controllable elements that provide radiation to points on the substrate that are on or near the pattern feature boundary. These can be not only to maximum or minimum intensity levels, but also to intensity levels between the maximum and minimum intensity levels. This is commonly referred to as "grayscaling."

Grayscaling provides greater control of the position of the pattern feature boundaries than is possible in a lithography system in which the radiation intensity provided to the substrate by a given individually controllable element can only be set to two values (namely just a maximum value and a minimum value). In an embodiment, at least three different radiation intensity values can be projected onto the substrate, e.g., at least 4 radiation intensity values, at least 8 radiation intensity values, at least 16 radiation intensity values, at least 32 radiation intensity values, at least 64 radiation intensity values, at least 128 radiation intensity values, or at least 256 radiation intensity values.

It should be appreciated that grayscaling can be used for additional or alternative purposes to that described above. For example, the processing of the substrate after the exposure can be tuned, such that there are more than two potential responses of regions of the substrate, dependent on received radiation dose level. For example, a portion of the substrate receiving a radiation dose below a first threshold responds in a first manner; a portion of the substrate receiving a radiation dose above the first threshold but below a second threshold responds in a second manner; and a portion of the substrate receiving a radiation dose above the second threshold responds in a third manner. Accordingly, grayscaling can be used to provide a radiation dose profile across the substrate having more than two desired dose levels. In an embodiment, the radiation dose profile has at least 2 desired dose levels, e.g., at least 3 desired radiation dose levels, at least 4 desired radiation dose levels, at least 6 desired radiation dose levels or at least 8 desired radiation dose levels.

It should further be appreciated that the radiation dose profile can be controlled by methods other than by merely controlling the intensity of the radiation received at each point on the substrate, as described above. For example, the radiation dose received by each point on the substrate can alternatively or additionally be controlled by controlling the duration of the exposure of the point. As a further example, each point on the substrate can potentially receive radiation in a plurality of successive exposures. The radiation dose received by each point can, therefore, be alternatively or additionally controlled by exposing the point using a selected subset of the plurality of successive exposures.

In order to form the required pattern on the substrate, it is necessary to set each of the individually controllable elements in the patterning device to the requisite state at each stage during the exposure process. Therefore, control signals, representing the requisite states, must be transmitted to each of the individually controllable elements. In one example, the lithographic apparatus includes a controller that generates the control signals. The pattern to be formed on the substrate can be provided to the lithographic apparatus in a vector-defined format, such as GDSII. In order to convert the design information into the control signals for each individually controllable element, the controller includes one or more data manipulation devices, each configured to perform a processing step on a data stream that represents the pattern. The data manipulation devices can collectively be referred to as the "datapath."

The data manipulation devices of the datapath can be configured to perform one or more of the following functions: converting vector-based design information into bitmap pattern data; converting bitmap pattern data into a required radiation dose map (namely a required radiation dose profile across the substrate); converting a required radiation dose map into required radiation intensity values for each individually controllable element; and converting the required radiation intensity values for each individually controllable element into corresponding control signals.

Figure 2 depicts an arrangement of the apparatus according to the present invention that can be used, e.g., in the manufacture of flat panel displays. Components corresponding to those shown in Figure 1 are depicted with the same reference numerals. Also, the above descriptions of the various embodiments, e.g., the various configurations of the substrate, the contrast device, the MLA, the beam of radiation, etc., remain applicable.

Figure 2 depicts an arrangement of a lithographic apparatus, according to one embodiment of the present invention. This embodiment can be used, e.g., in the manufacture of flat panel displays. Components corresponding to those shown in Figure 1 are depicted with the same reference numerals. Also, the above descriptions of the various embodiments, e.g., the various configurations of the substrate, the contrast device, the MLA, the beam of radiation, etc., remain applicable.

As shown in Figure 2, the projection system PS includes a beam expander, which comprises two lenses L1, L2. The first lens L1 is arranged to receive the modulated radiation beam B and focus it through an aperture in an aperture stop AS. A further lens AL can be located in the aperture. The radiation beam B then diverges and is focused by the second lens L2 (e.g., a field lens).

The projection system PS further comprises an array of lenses MLA arranged to receive the expanded modulated radiation B. Different portions of the modulated radiation beam B, corresponding to one or more of the individually controllable elements in the patterning device PD, pass through respective different lenses in the array of lenses MLA. Each lens focuses the respective portion of the modulated radiation beam B to a point which lies on the substrate W. In this way an array of radiation spots S is exposed onto the substrate W. It will be appreciated that, although only eight lenses of the illustrated array of lenses 14 are shown, the array of lenses can comprise many thousands of lenses (the same is true of the array of individually controllable elements used as the patterning device PD).

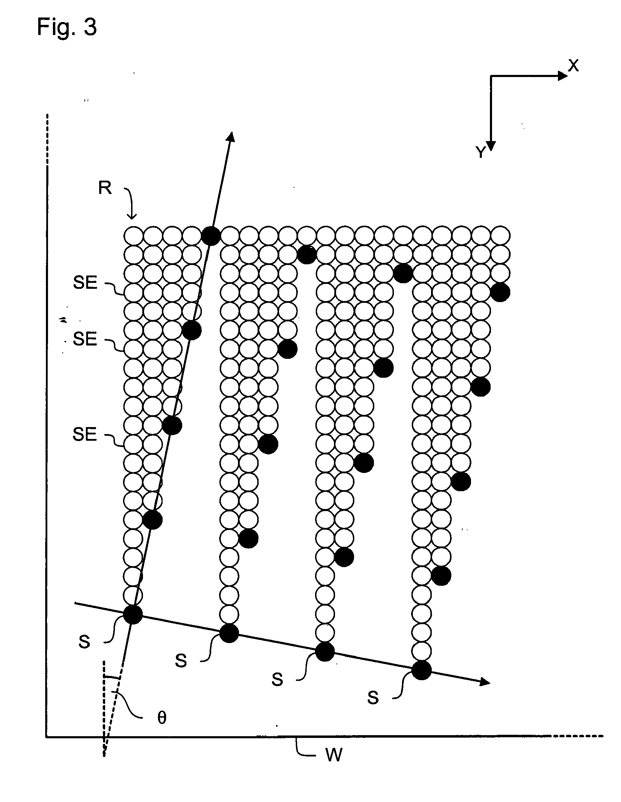

Figure 3 illustrates schematically how a pattern on a substrate W is generated using the system of Figure 2, according to one embodiment of the present invention. The filled in circles represent the array of spots S projected onto the substrate W by the array of lenses MLA in the projection system PS. The substrate W is moved relative to the projection system PS in the Y direction as a series of exposures are exposed on the substrate W. The open circles represent spot exposures SE that have previously been exposed on the substrate W. As shown, each spot projected onto the substrate by the array of lenses within the projection system PS exposes a row R of spot exposures on the substrate W. The complete pattern for the substrate is generated by the sum of all the rows R of spot exposures SE exposed by each of the spots S. Such an arrangement is commonly referred to as "pixel grid imaging," discussed above.

It can be seen that the array of radiation spots S is arranged at an angle θ relative to the substrate W (the edges of the substrate lie parallel to the X and Y directions). This is done so that when the substrate is moved in the scanning direction (the Y-direction), each radiation spot will pass over a different area of the substrate, thereby allowing the entire substrate to be covered by the array of radiation spots 15. In one example, the angle θ is at most 20°, 10°, e.g., at most 5°, at most 3°, at most 1°, at most 0.5°, at most 0.25°, at most 0.10°, at most 0.05°, or at most 0.01°. In one example, the angle θ is at least 0.001°.

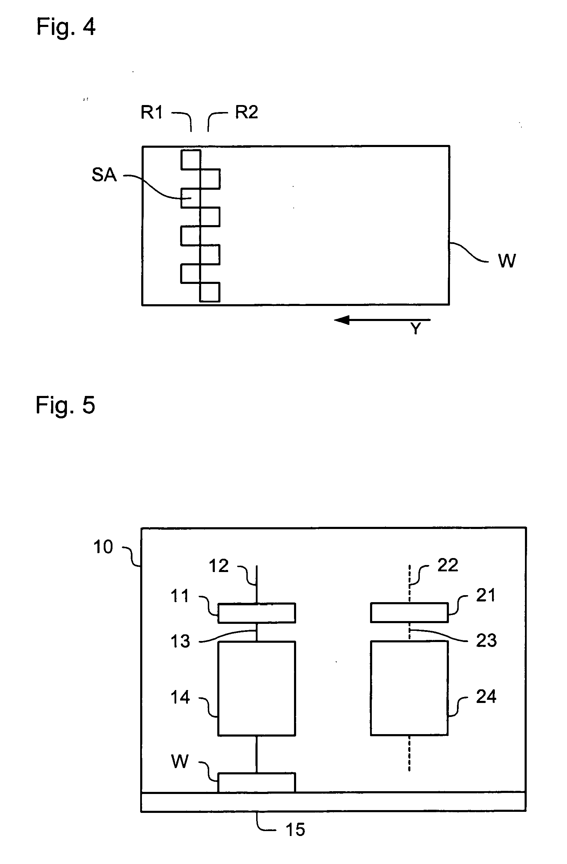

Figure 4 shows schematically how an entire flat panel display substrate W can be exposed in a single scan using a plurality of optical engines, according to one embodiment of the present invention. In the example shown eight arrays SA of radiation spots S are produced by eight optical engines (not shown), arranged in two rows R1, R2 in a "chess board" configuration, such that the edge of one array of radiation spots S slightly overlaps (in the scanning direction Y) with the edge of the adjacent array of radiation spots. In one example, the optical engines are arranged in at least 3 rows, for instance 4 rows or 5 rows. In this way, a band of radiation extends across the width of the substrate W, allowing exposure of the entire substrate to be performed in a single scan. It will be appreciated that any suitable number of optical engines can be used. In one example, the number of optical engines is at least 1, e.g., at least 2, at least 4, at least 8, at least 10, at least 12, at least 14, or at least 17. In one example, the number of optical engines is less than 40, e.g., less than 30 or less than 20.

Each optical engine can comprise a separate illumination system IL, patterning device PD and projection system PS as described above. It is to be appreciated, however, that two or more optical engines can share at least a part of one or more of the illumination system, patterning device and projection system.

### First Aspect of the Invention

According to a first embodiment of the invention, a lithographic apparatus is provided having at least one array of individually controllable elements that is configured to expose a pattern on a substrate by the combination of one or more exposures of the first type and one or more exposures of a second type. For exposures of the first type, a beam of radiation is modulated by an array of individually controllable elements in the lithographic apparatus and projected on to the substrate to form a repeating pattern. For exposures of the second type, a beam of radiation is also modulated by an array of individually controllable elements in the lithographic apparatus and projected on to the substrate. However, for exposures of the second type, the size of a portion of the exposure on the substrate corresponding to an individually controllable element is larger than the portion of the exposure on the substrate corresponding to an individually controllable element for an exposure of the first type.

Accordingly, the pattern projected onto the substrate by an exposure of the first type has a relatively higher resolution, but is limited to a repeating pattern. In contrast, an exposure of the second type has a relatively lower resolution but can be more flexible. The combination of the two exposures can provide a convenient compromise of the flexibility of the pattern to be formed is provided by the exposure of the second type. However, because the resolution of the exposure of the second type is limited, the amount of data required in order to set the array of individually controllable elements is relatively small. Meanwhile, the critical dimension of the overall pattern formed is determined by the resolution of the exposure of the first type. Accordingly, because the resolution of the exposure of the first type is relatively high, relatively small critical dimension patterns (CD) are attainable. However, because the exposure of the first type merely contains a repeating pattern (which can be the same for all devices formed by the lithographic apparatus, for all devices formed on a batch of substrates, for all devices formed on a given substrate, and/or for all exposures used to form all or part of a device on a substrate, for example), a relatively small amount of data is required to set the individually controllable elements.

Accordingly, the lithographic apparatus according to the first embodiment of the present invention can form a pattern having low critical dimension values, while providing flexibility of the pattern to be formed with a relatively modest requirement for data to set the one or more arrays of individually controllable elements within the apparatus. Reducing the data rate can reduce the cost and complexity of the processing units required to generate the control signals for the array of individually controllable elements. Furthermore, reducing the data rate can allow the arrays of individually controllable elements to be updated more frequently, which can increase the substrate throughput of the lithographic apparatus, improving its cost-effectiveness.

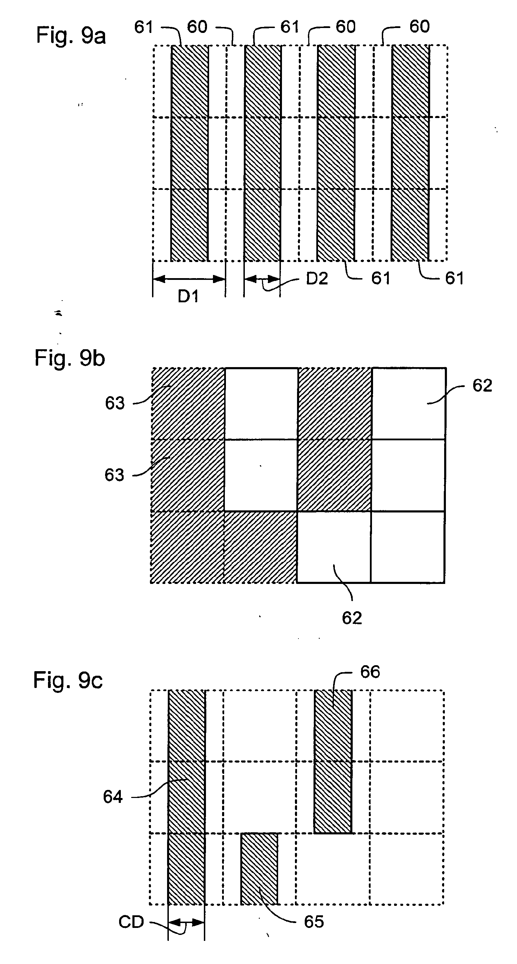

Figures 9a, 9b and 9c depict how exposures of the first type and the second type can be combined to form a desired pattern, according to one embodiment of the present invention. Figure 9a depicts a repeating pattern that can be projected onto the substrate in an exposure of the first type. As shown, the repeating pattern consists of a plurality of lines 60 of relatively high radiation intensity inter dispersed by lines 61 of relatively low radiation intensity.

Figure 9b depicts the pattern of radiation that can be projected onto the substrate in an exposure of the second type. As shown, a plurality of individually controllable elements are set such that the corresponding portion 62 of the beam of radiation that is projected onto the substrate has a relatively high radiation intensity and the remaining individually controllable elements, corresponding to the remaining portions 63 of the beam of radiation projected on the substrate, are set such that the radiation intensity is relatively low. For convenience of comparison, broken lines are shown in Figure 9a (which depicts an exposure according to the first type), showing the distribution of the portions 62,63 of a beam of radiation, corresponding to each individually controllable element, in an exposure of the second type. As shown, the width D1 of the portions 62,63 of a beam of radiation, corresponding to each individually controllable element, in an exposure according to the second type are larger than the width D2 of the pattern features projected onto the substrate in an exposure of the first type. In other words, the resolution of the pattern projected onto the substrate in an exposure of the first type is higher than the resolution of the pattern projected onto the substrate in an exposure of the second type.

Figure 9c depicts the exposure resulting from a combination of the exposure of the first type depicted in Figure 9a and the exposure of the second type depicted in Figure 9B. As shown, the pattern features 64,65,66 correspond to portions of the high resolution features of the pattern projected onto the substrate by the exposure of the first type, trimmed by the relatively low resolution pattern projected onto the substrate by the exposure of the second type. Accordingly, the pattern is defined by the relatively low resolution exposure according to the second type but the critical dimension CD of the pattern features is defined by the relatively high resolution exposure of the first type.

Although the repeating pattern shown in Figure 9a can conveniently be used as the repeating pattern in an exposure of the first type, for forming pattern features that are elongate in a direction parallel to the lines of the repeating pattern, it can be desirable to form more complicated pattern features.

Such more complicated pattern features can be formed, for example, by forming a first set of pattern features such as those shown in Figure 9c by performing an exposure of the first type, such as that shown in Figure 9a, and an exposure of the second type, such as that shown in Figure 9b, to trim the repeating pattern exposed in the exposure of the first type. Subsequently, a second group of pattern features, elongate in a different direction, can be formed by performing a second exposure according to the first type to generate a different high resolution repeating pattern and performing a second exposure according to the second type to trim the second repeating pattern. The pattern for the second exposure of the first type can again be a plurality of lines, similar to those depicted in Figure 9a, but parallel to a direction orthogonal to the lines of the first exposure of the first type, for example. Therefore, the combination of the first exposure of the first type and the first exposure of the second type are used to form elongate pattern features parallel to a first direction and the combination of the second exposure of the first type and the second exposure of the second type are used to form elongate pattern features parallel to a second direction, orthogonal to the first direction. Accordingly, a pattern comprising a mixture of features that are elongate in two orthogonal directions can be generated.

It will be appreciated that the lines of the second exposure of the first type need not be perpendicular to the lines of the first exposure of the first type, but can be at an oblique angle, permitting further variation in the final pattern to be formed. Likewise, additional exposures of the first and second type can be used in order to generate patterns of greater complexity.

Alternatively or additionally, the repeating pattern used for an exposure of the first type can be a pattern other than the pattern shown in Figure 9a.

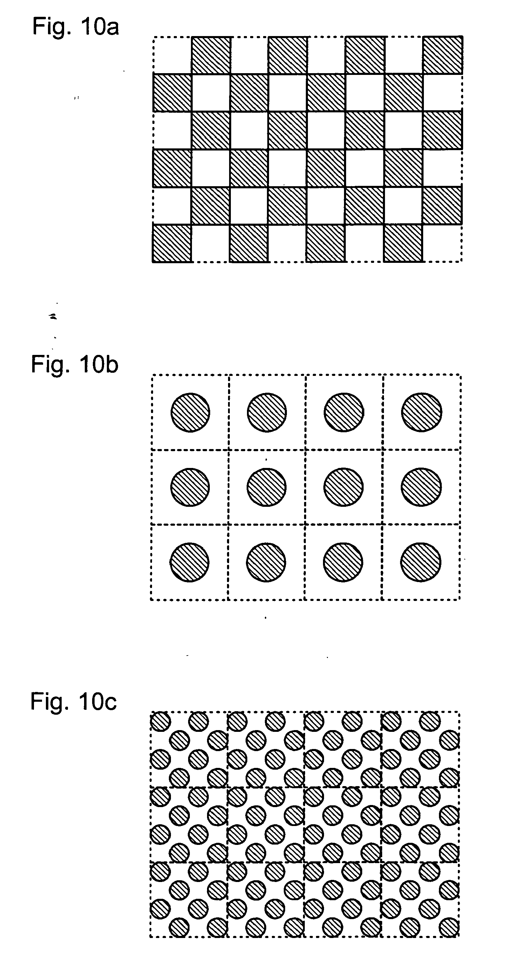

Figures 10a, 10b and 10c depict examples of other repeating patterns that can be used, according to various embodiments of the present invention. As shown in Figure 10a, the repeating pattern can be a checker board pattern or, as shown in Figures 10b and 10c, the repeating pattern can be comprised of a plurality of circles. Alternatively or additionally, the repeating pattern can correspond to a repeating unit of a device to be formed on a substrate. For example, in the formation of a DRAM integrated circuit device, the pattern for the unit cell (the memory part) is repeated many times. Accordingly, the repeating pattern of the first exposure can correspond to part or all of such a unit cell.

### First Exemplary Embodiment

Figure 5 depicts a first embodiment of the first aspect of the invention. As shown, the lithographic apparatus 10 includes a first array of individually controllable elements 11 that modulate a first beam of radiation 12 to form a first modulated beam of radiation 13. A first projection system 14 is used to project the first modulated beam of radiation 13 onto a substrate W. The first array of individually controllable elements 11 and the first projection system 14 are used to perform exposures of the first type.

The lithographic apparatus 10 further includes a second array of individually controllable elements 21 that can be used to modulate a second beam of radiation 22 to form a second modulated beam of radiation 23. The second modulated beam of radiation 23 can be projected onto a substrate W using a second projection system 24. The second array of individually controllable elements 21 and the second projection system 24 are used to perform exposures of the second type.

**[00100]** Figure 5 depicts a substrate W being exposed by the first array of individually controllable elements and the first projection system, e.g., an exposure of the first type. It will be appreciated, however, that the lithographic apparatus 10 can be configured such that while a first substrate is receiving an exposure of the first type, a second substrate is receiving an exposure of the second type. Likewise, the lithographic apparatus 10 can be configured such that while a first portion of a substrate is receiving an exposure of the first type, a second portion of the second substrate is receiving an exposure of the second type.

As shown, the lithographic apparatus 10 includes a substrate table 15 that supports the substrate W in a first position in order to receive an exposure of the first type, transports the substrate W to a second position and supports substrate W at the second position while it receives an exposure of the second type. It will be appreciated that separate substrate tables can be provided for supporting the substrate at the first and second positions. In that case, the lithographic apparatus 10 can include a substrate handler for transferring the substrate between first and second positions. It will further be appreciated that when the substrate is held in the first or the second position, the substrate can be moved relative to the first or second projection system 14,24, respectively, such that the substrate W can receive a plurality of exposures of the first and second type, respectively, at different locations on the substrate.

It should be understood that although Figure 5 depicts the arrays of individually controllable elements 11,21, as transmissive, this is merely for convenience of representation and one or both of the arrays of individually controllable elements 11,21 can instead be of a reflective type, as discussed above. It should also be appreciated that a plurality of arrays of individually controllable elements can be used to perform one or both of the first and second types of exposure. Any such plurality of arrays of individually controllable elements for performing one of the first and second types of exposure can be used in conjunction with a single projection system. Alternatively, a plurality of projection systems can be used for performing the exposures of one or both of the first and second types of exposures.

The first and second beams of radiation 12,22 can be provided by separate radiation sources. Alternatively, the first and second beams of radiation 12,22 can be provided by a common radiation source. In such a case, the lithographic apparatus 10 can include a beam divider for dividing a beam of radiation provided by the radiation source into the first and second beams of radiation 12,22. Alternatively or additionally, the lithographic apparatus 10 can include a radiation beam switcher that either directs the beam of radiation from the radiation source to the first array of individually controllable elements 11, such that the beam of radiation from the radiation source constitutes the first beam of radiation 12, or directs the beam of radiation from the radiation source to the second array of individually controllable elements 21 such that the beam of radiation from the radiation source constitutes the second beam of radiation 22.

As discussed above, the resolution of the pattern projected on to the substrate by the first array of individually controllable elements 11 and the first projection system 14 is higher than the resolution of the pattern projected onto the substrate by the second array of individually controllable elements 21 and the second projection system 24. In other words, the size of the exposure projected onto the substrate corresponding to a single individually controllable element is larger for an exposure of the second type than for an exposure of the first type. In order to achieve this, the individually controllable elements of the first array of individually controllable elements 11 can be smaller than the individually controllable elements of the second array of individually controllable elements 21. Alternatively or additionally, the demagnification of the first projection system, 14 can be larger than the demagnification of the second projection system 24.

### Embodiment 2

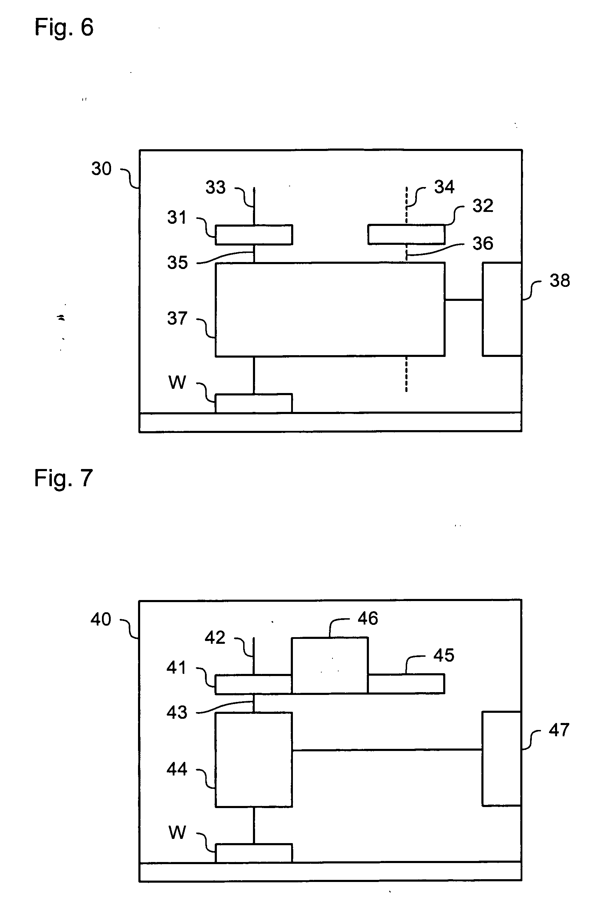

Figure 6 depicts a second embodiment of the first aspect of the present invention. This embodiment is similar to the first embodiment. Accordingly the description of similar components and/or aspects will not be repeated. Similarly, it will be understood that the variants to the first embodiment discussed above can also be applied to this embodiment.

As shown, a lithographic apparatus 30 according to the second embodiment includes first and second arrays of individually controllable elements 31,32. The first and second arrays of individually controllable elements 31,32 are used to modulate first and second beams of radiation 33,34 to form first and second modulated beams of radiation 35,36. A projection system 37 is used to project the first modulated beam of radiation 35 onto a substrate W in an exposure of the first type. The same projection system 37 can be used to project the second modulated beam of radiation 36 onto the substrate to perform an exposure of the second type. Accordingly, the difference between the first and second embodiments is that a common projection system is used for exposures of both the first and second types.

Although as shown in Figure 6, the first and second arrays of individually controllable elements 31,32 can be set apart, in practice they can be relatively closer together in order to minimize the size of the optical elements required in the projection system 37. Indeed, if a first plurality of arrays of individually controllable elements are used to modulate the beam of radiation 33 for exposures of the first type and a second plurality of arrays of individually controllable elements are used to modulate the second beam of radiation 34 for exposures of the second type, the first and second pluralities of arrays of individually controllable elements can be interspersed. It will be appreciated, therefore, that the substrate can, in a single position, be able to receive exposures of both the first and the second types.

In order to provide a higher resolution for exposures of the first type than for exposures of the second type, the individually controllable elements of the first array of individually controllable elements 31, can be smaller than the individually controllable elements of the second array of individually controllable elements 32.

Alternatively or additionally, the projection system 37 can be configured such that its demagnification can be changed between exposures of the first and second types. For example, the projection system 37 can be set to have a relatively high demagnification during exposures of the first type and a relatively low demagnification during exposures of the second type. This can be effected by adjusting the relative position of two or more optical elements within the projection system 37, by adding additional optical elements into the radiation beam path and/or by removing optical elements from the radiation beam path. Accordingly, the lithographic apparatus 30 can be provided with a magnification controller 38 that is used to set the demagnification of the projection system 37 and to switch it between desired levels of demagnification between exposures of the first and second types.

It should be appreciated that the projection system 37 can include a system configured to measure the demagnification of the projection system and to feed the measurement back to the magnification controller 38 in order to ensure an accurate setting.

Alternatively or additionally, the resolution of the lithographic system can be changed between exposures of the first type and exposures of the second type by changing the numerical aperture (NA), for example by changing the angular intensity distribution of the radiation beam conditioned by the illuminator IL as discussed above.

### Embodiment 3

Figure 7 depicts a third embodiment of the first aspect of the present invention. This embodiment is similar to the first and second embodiments. Accordingly the description of similar components and/or aspects will not be repeated. Similarly, it will be understood that the variants to the first and second embodiments discussed above can also be applied to this embodiment.

As depicted, the lithographic apparatus 40 of the third embodiment includes a first array of individually controllable elements 41 that can be used to modulate a first beam of radiation 42 to form a first modulated beam of radiation 43. The first modulated beam of radiation 43 is projected onto the substrate W using a projection system 44. Accordingly, exposures of the first type can be performed by modulating the beam of radiation 42 with the first array of individually controllable elements and projecting the modulated beam of radiation 43 onto the substrate W using the projection system 44.

The lithographic apparatus 40 also includes a second array of individually controllable elements 45 and an array exchanging mechanism 46. The array exchanging mechanism 46 is constructed such that the first array of individually controllable elements 41 can be replaced with the second array of individually controllable elements 45 in order to perform an exposure of the second type.

In operation, the lithographic apparatus can perform exposures of the first type when configured as shown in Figure 7. In order to perform exposures of the second type, the array exchanging mechanism 46 switches the position of the first and second arrays of individually controllable elements 41,45. In this second configuration, the beam of radiation 42 is modulated by the second array of individually controllable elements 45. The beam of radiation modulated by the second array of individually controllable elements 45 is then projected onto the substrate W using the projection system 44.

Therefore, the lithographic apparatus 40 switches between exposures of the first type and exposures of the second type by means of interchanging the first and second arrays of individually controllable elements 41,45 by means of the array exchanging mechanism 46. As a result, for a given size of exposure field for each of the exposures of the first and second type, the elements within the projection system 44 of the lithographic apparatus 40 of the third embodiment can be smaller than the elements of the projection system 37 of the second embodiment.

As in the second embodiment, the higher resolution of the exposures of the first type relative to the exposures of the second type can be attained by the individually controllable elements of the first array of individually controllable elements 41 being smaller than the individually controllable elements of the second array of individually controllable elements 45. Alternatively or additionally, the demagnification of the projection system 44 can be controlled by a magnification controller 47 such that the demagnification of the projection system 44 is greater for exposures of the first type than it is for exposures of the second type. Alternatively or additionally, the resolution can be changed by adjusting the numerical aperture (NA) of the system as discussed above.

In a variant of the third embodiment of the first aspect of the present invention, the array exchanging mechanism 46 can be replaced by a radiation beam directing mechanism. The radiation beam directing mechanism can be configured such that the first beam of radiation 42 can be directed to either one of the first and second arrays of individually controllable elements 41,45. Likewise, the radiation beam directing mechanism can subsequently direct the beam of radiation that has been modulated by the one of the first and second arrays of individually controllable elements 41,45, to the projection system 44. The radiation beam directing mechanism can comprise, for example, one or more reflective or refractive elements that can be actuated between two or more positions in order to direct radiation in a selected one of a plurality of directions. Such an arrangement provides all of the advantages of the third embodiment, as depicted in Figure 7. For example, being able to configure different arrays of individually controllable elements for each of the exposures of the first and second types without requiring a relatively large projection system. It also permits the arrays of individually controllable elements to be mounted in a fixed manner rather than movable relative to the remainder of the lithographic apparatus. Accordingly, the provision of, for example, control signals to the arrays of individually controllable elements is simplified.

### Embodiment 4

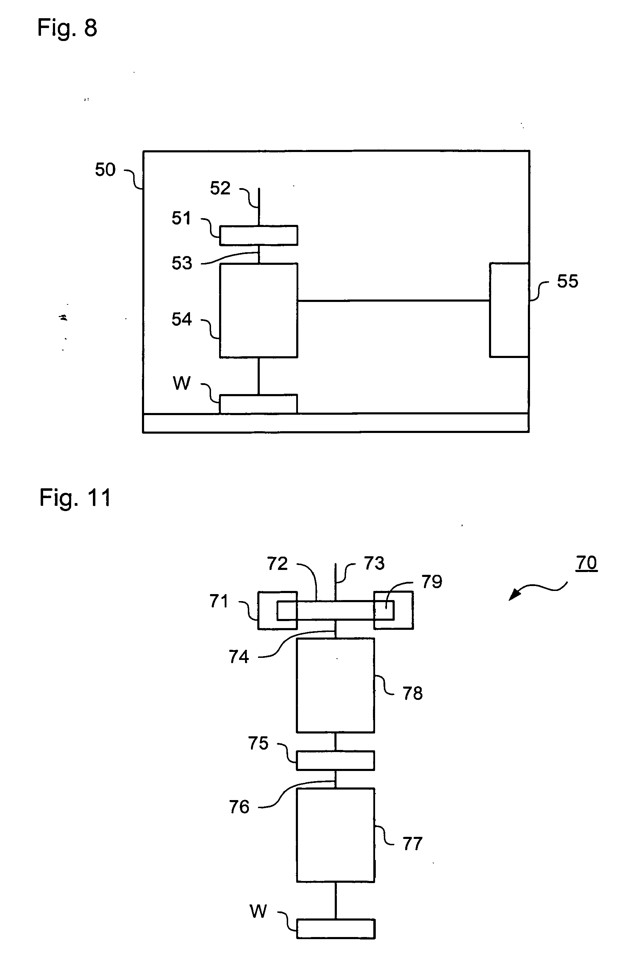

Figure 8 depicts a lithographic apparatus 50 according to a fourth embodiment of the first aspect of the present invention. This embodiment is similar to the previously described embodiments of this first aspect. Accordingly the description of similar components and/or aspects will not be repeated. Similarly, it will be understood that the variants to the previously described embodiments of this aspect discussed above can also be applied to this embodiment.

As depicted, the lithographic apparatus 50, includes an array of individually controllable elements 51 configured to modulate a beam of radiation 52 to form a modulated beam of radiation 53. A projection system 54 projects the modulated beam of radiation 53 onto the substrate W. Exposures of both the first and second type are performed using the same array of individually controllable elements 51 and the same projection system 54. The projection system 54 is constructed such that its de-magnification can be adjusted and controlled by a magnification controller 55 in the same way as discussed above. Accordingly, exposures of the first type are performed by modulating the beam of radiation 52 with the array of individually controllable elements and projecting the modulated beam of radiation 53 onto the substrate W using the projection system 54 set at a first, relatively high demagnification setting. Accordingly the pattern projected onto the substrate W has a relatively high resolution. For exposures of the second type, the beam of radiation 52 is modulated by the array of individually controllable elements 51. The modulated beam of radiation 53 is projected onto the substrate W using the projection system 54 set to a lower demagnification value, such that the pattern that is projected onto the substrate has a lower resolution than that provided by exposures of the first type.

### Second Aspect of the Invention

### Embodiment 5

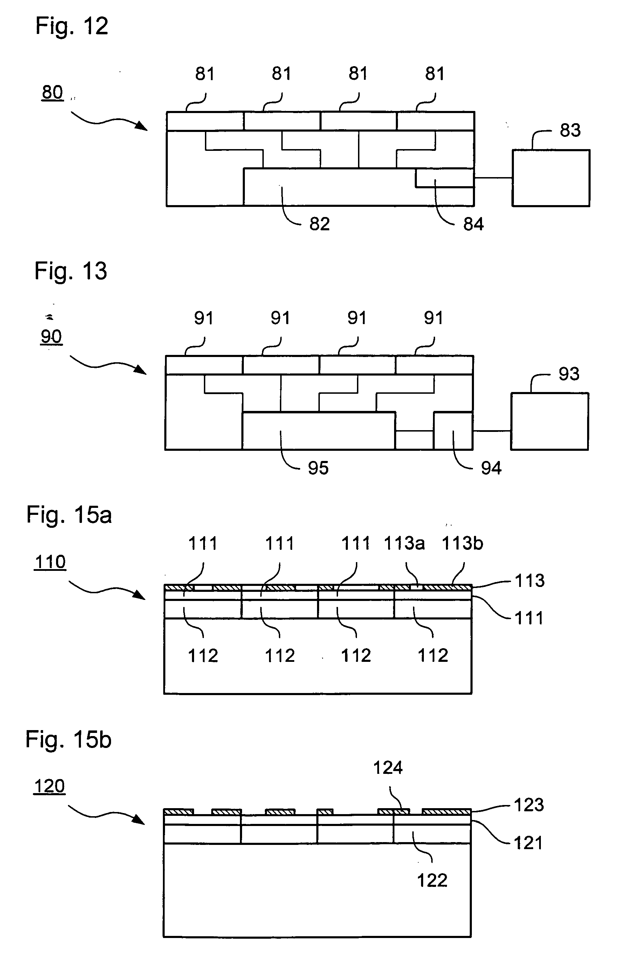

Figure 11 depicts a first embodiment of the lithographic apparatus of a second aspect of the present invention. As shown, the lithographic apparatus 70, includes a support 71 constructed to support a patterning device 72 that modulates a beam of radiation 73 to form a modulated beam of radiation 74. The modulated beam of radiation 74 is further modulated by an array of individually controllable elements 75 to form a second modulated beam of radiation 76. The second modulated beam of radiation 76 is projected onto the substrate W by means of a projection system 77. As shown in Figure 11, a second projection system 78 can be provided to project the first modulated beam of radiation 74 onto the array of individually controllable elements 75.

In a similar fashion to the first aspect of the invention discussed above, the patterning device 72 of the second aspect modulates the beam of radiation 73 with a relatively high resolution pattern and the array of individually controllable elements 75 has a relatively low resolution and is used to trim the pattern provided by the patterning device 72. As before, the relatively high resolution pattern imparted to the beam of radiation by the patterning device 72 can be a repeating pattern. The patterning device 72 can be a mask or can be a second array of individually controllable elements.

An arrangement such as the first embodiment of the second aspect provides the same benefits as the first four embodiments of the first aspect. For example, obtaining high resolution pattern features from a first patterning device, while retaining flexibility in the pattern selection by the use of an array of individually controllable elements in order to trim the pattern. However, the apparatus of the first embodiment of the second aspect has the additional advantage that the high resolution exposure and the trim exposure are combined into a single exposure. Accordingly, the exposure time to provide a desired pattern can be reduced.

As discussed above in relation to Figures 9a, 9b, 9c and 10a, 10b and 10c, it can be desirable to modulate the beam of radiation 73 with different patterns using the relatively high resolution patterning device 72. Clearly, an array of individually controllable elements used as a patterning device 72 can be beneficial. However, a mask can also be used as the patterning device 72. In such a case, the support 71 can be constructed such that the mask can be replaced, for example, between the exposure of batches of substrates, between exposures of entire substrates, between the exposure of patterns corresponding to complete devices to be formed on a substrate and/or between the formation of different portions of devices on the substrate. Different masks can be used for the formation of different functional components of devices formed on a substrate. Given the relatively limited number of patterns that can be required, a dedicated unit can be provided that includes a plurality of masks corresponding to each of the required patterns and a mechanism for interchanging them such that the beam of radiation 73 can be modulated by the appropriate pattern at the appropriate time.

As discussed above, it can be desirable to use a similar relatively high resolution pattern at more than one orientation, for example to modulate the beam of radiation 73 with a plurality of lines oriented in a first direction for some exposures and oriented in a perpendicular direction for other exposures. Therefore, the substrate holder 71 can include a rotating mechanism 79 constructed to rotate the patterning device 72 about an axis parallel to the optical axis of the lithographic apparatus 70.

### Third Aspect of the Invention

### Embodiment 6

Figure 12 depicts a first embodiment of a third aspect of the present invention. Figure 12 shows an array 80 of individually controllable elements 81 that may also be used with any of the embodiments discussed above. It will be appreciated that, although the array of individually controllable elements depicted only includes four individually controllable elements, in practice such an array 80 can include many more individually controllable elements. The array of individually controllable elements 80 includes a memory 82 that stores control signals, or data corresponding to the control signals, necessary to set the individually controllable elements of the array 80 to the necessary states in order to modulate a beam of radiation with a desired repeating pattern. The lithographic apparatus includes a pattern controller 83, constructed to set the individually controllable elements 81 of the array 80 to the states, defined by the data stored in the memory, when required.

The memory 82 in the array 80 of individually controllable elements 81 can store the data corresponding to the control signals necessary to set a group of individually controllable elements 81 to the required states in order to provide a single repeating unit of the repeating pattern. These control signals can then be provided to a plurality of groups of individually controllable elements 81 such that the repeating pattern is repeated across the array 80.

In order to improve the accuracy of the pattern that is set on the array of individually controllable elements, the memory 82 can include appropriate calibration and/or correction factors for individual individually controllable elements 81 or groups of individually controllable elements that are applied to the basic control signals before they are supplied to each of the individually controllable elements. Alternatively, the memory 82 can store data corresponding to each of the control signals necessary for each of the individually controllable elements 81 in order to set the array of individually controllable elements to provide the repeating pattern. Each of these individually stored control signals can include any appropriate calibration and/or correction factors. The array of individually controllable elements can further include a mechanism for updating the calibration and/or correction factors for each individually controllable element and/or the control signals stored for each individually controllable element.

The array of individually controllable elements 80 can be constructed such that it can conveniently be set to one of a plurality of different patterns. For example, the memory 82 can contain the data necessary for a plurality of patterns. In this case, the array 80 of individually controllable elements can include a pattern selection unit 84. The pattern selection unit 84 receives a control signal from the pattern controller 83 indicative of the selection of a desired repeating pattern from the plurality stored in the memory 82. Subsequently, the pattern selection unit 84 selects the appropriate data from the memory 82 such that the appropriate control signals are applied to the individually controllable elements 81.

It should be appreciated that, in place of a memory that stores control signals or data corresponding to control signals necessary to set the individually controllable elements of the array 80 to the necessary state in order to modulate a beam of radiation with a desired repeating pattern, the array of individually controllable elements can instead be hard-wired to provide the requisite pattern. Therefore, the array of individually controllable elements 80 can comprise dedicated circuits to direct a control signal from the pattern controller 83 to a portion of the individually controllable elements in order to set them to the requisite state. For example, in a relatively simple scenario, the dedicated circuits can simply be transmission lines that direct the control signal to alternate individually controllable elements within each row and/or column. Accordingly, when the control signal is supplied by the pattern controller 83, half of the individually controllable elements switch to a different state and the remainder will remain unchanged. Accordingly, a repeating pattern is provided to the array of individually controllable elements by the provision of a single control signal.

It should be appreciated that more complex dedicated circuits can be provided, for example to provide different patterns. Likewise, the dedicated circuits can, as above, include an arrangement for applying calibration and/or correction factors to the control signal before it is provided to the individually controllable elements. It should also be appreciated that the array of individually controllable elements can be provided with a plurality of dedicated circuits, each corresponding to a different repeating pattern. Accordingly, by providing the control signal to a selected one of the dedicated circuits, it is possible to select a desired repeating pattern. Similarly, it should be appreciated that an array of individually controllable elements can include conventional control circuitry, for example to provide matrix addressing of the individually controllable elements as well as one or more dedicated circuits as described above such that the array of individually controllable elements can be set to one of the repeating patterns set by the dedicated circuit or to any desired pattern using the conventional control circuits.

### Embodiment 7

Figure 13 depicts an array 90 of individually controllable elements 91 that can alternatively or additionally be used to provide a repeating pattern in any of the first to fifth embodiments discussed above. As before, a pattern controller 93 is provided in order to set the array of individually controllable elements, such that it provides a required repeating pattern. In this case, the array 90 of individually controllable elements includes a pattern receiver 94 for receiving, from the controller 93, control signals corresponding to those that must be provided to a group of individually controllable elements 91 in order to set that group to provide a repeating unit of a pattern to be provided by the array 90 or data corresponding to such control signals. The array 90 further includes a control signal distributor 95, which receives the data or the control signals from the pattern receiving unit 94 and distributes the required control signals to a plurality of groups of individually controllable elements 91, such that each of the plurality of groups of individually controllable elements is set to provide the repeating unit of the pattern, as specified by the pattern controller 93.

In a similar manner to that discussed above in relation to the sixth embodiment, the control signal distributor 95, can include a memory that stores correction and/or calibration factors necessary to be applied to the control signals for each of the individually controllable elements in order to obtain the required response from the individually controllable elements 91.

An advantage of an array of individually controllable elements according to the sixth embodiment is that a simple control signal is all that is required to set the array of individually controllable elements to provide the repeating pattern or a selected one of a plurality of repeating patterns. Accordingly, the pattern controller is relatively simple. An advantage of the arrangement of the seventh embodiment is that it is far more flexible because a greater variety of repeating patterns can be provided.

### Fourth Aspect of the Invention

### Embodiment 8

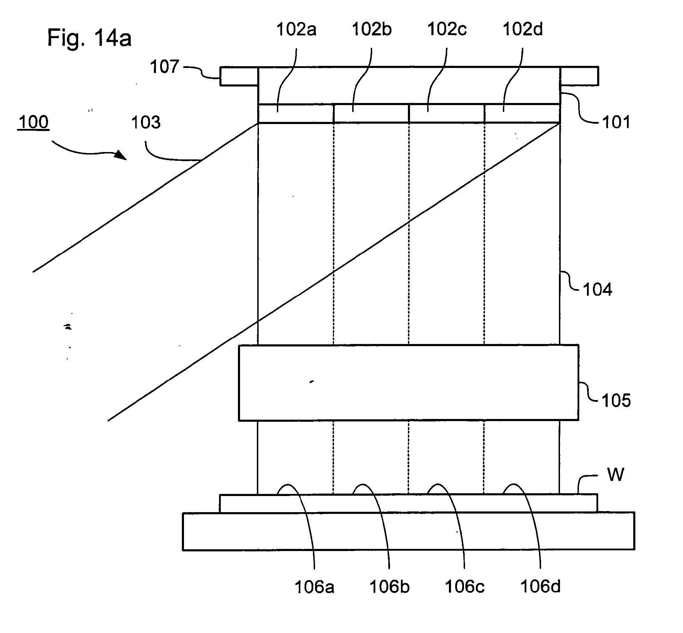

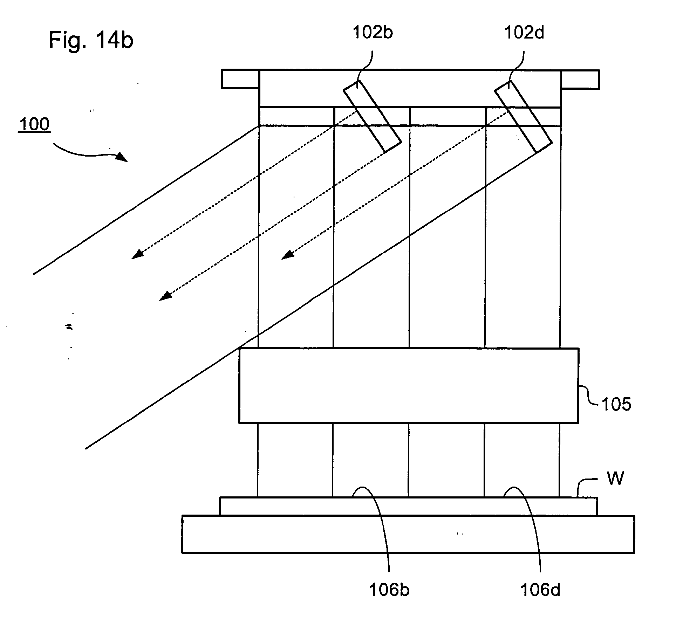

Figures 14a and 14b depict a portion of the lithographic apparatus of a first embodiment of a fourth aspect of the invention. As shown, the lithographic apparatus 100, includes an array 101 of individually controllable elements 102 that modulate a beam of radiation 103. The modulated beam of radiation 104 is projected onto a substrate W by a projection system 105.

Figure 14a depicts the apparatus 100 in a first operating condition, in which all of the individually controllable elements 102 of the array 101 are set such that the corresponding portion of the beam of radiation 103 is directed via the projection system 105 to the substrate W.

Figure 14b depicts the lithographic apparatus 100 in a second operating condition, in which some of the individually controllable elements 102b,102d are set such that the corresponding portion 106b,106d of the beam of radiation 103 is not directed via the projection system 105 to the substrate W. As before, it should be appreciated that although the lithographic apparatus 100 has been depicted as having a patterning device of a reflective type, it could also be transmissive.

According to the fourth aspect of the invention, depicted in Figures 14a and 14b, each of the individually controllable elements 102a,102b,102c,102d is constructed to impart a pattern to the corresponding portion 106a, 106b, 106c, 106d of the beam of radiation that is projected onto the substrate W. Therefore, in a similar manner to the first two aspects of the invention (e.g., embodiments one through five), a relatively high resolution pattern is provided and trimmed by an array of individually controllable elements. In this case, the relatively high resolution pattern is formed directly on each of the individually controllable elements of the array 101 used to trim the high resolution pattern.

As shown in Figure 14b, when the individually controllable elements 102b,102d are set to a given state, the corresponding portion 106b,106d of the relatively high resolution pattern is not projected onto the substrate W. Accordingly, compared to the first through fourth embodiments according to the first aspect of the invention, the exposure time for a substrate is reduced because the relatively high resolution exposure and the relatively low resolution exposure are combined.

The relatively high resolution pattern imparted by each of the individually controllable elements 102a,102b,102c,102d can be the same. In other words, the array of individually controllable elements can impart a repeating pattern to the beam of radiation, each repeating unit being no larger than the size of the portion of the modulated beam of radiation 104 corresponding to each of the individually controllable elements 102a,102b,102c,102d. The pattern can be arranged, however, such that the repeating units of the relatively high resolution pattern are formed by a group of adjacent individually controllable elements. It will be appreciated that any of the repeating patterns discussed above can be used with this aspect of the invention.

As discussed above, for some selections of relatively high resolution repeating patterns, such as a repeating pattern of a plurality of lines, it can be desirable to perform two or more exposures, each with the relatively high resolution pattern oriented at a different angle from the other exposures. For example, it can be desirable to perform a first exposure in which the high resolution pattern comprises a plurality of lines parallel to a given direction and a second exposure in which the high resolution pattern is oriented such that the plurality of lines are, for example, perpendicular to the first direction. Therefore, the array 101 of individually controllable elements can mounted in the lithographic apparatus 100 by way of a rotating support 107 that supports the array of individually controllable elements and can rotate it about an axis perpendicular to the optical axis of the lithographic apparatus, such that the orientation of the relatively high resolution pattern formed on the individually controllable elements 102a, 102b, 102c, 102d can be changed.

. The relatively high resolution pattern can be formed on the individually controllable elements by any one of a number of suitable means.

Figure 15a depicts an array of individually controllable elements 110 that can be used with an apparatus, such as depicted in Figures 14a and 14b, according to one embodiment of the present invention. The array is formed from a plurality of reflective individually controllable elements 111, each associated with an actuator 112 configured to, for example, rotate the individually controllable element 111 about a line parallel to its planar surface. In order to provide the relatively high resolution pattern, portions of the reflective surface 113 of the individually controllable elements are modified to increase or decrease their reflectivity, such that regions of relatively high reflectivity 113a and regions of relatively low reflectivity 113b, are formed on the surface. The modifications can include at least one of altering the surface texture of the individually controllable element, such as polishing the surface or scuffing the surface, selective deposition of material on the surface of the reflector, for example with a lower reflectivity material, and selective removal of material from the surface of the reflector, for example to expose a lower reflectivity surface below. A similar arrangement can be used with transmissive individually controllable elements but in which regions of relatively higher and relatively lower transmissivity are formed.

Figure 15b depicts a variant of the array of individually controllable elements depicted in Figure 15a, according to one embodiment of the present invention. In this case, each of the individually controllable elements 121 has an associated actuator 122, constructed to move the individually controllable element as required. The individually controllable elements have a reflective surface 123 on which a plurality of reflective protrusions 124 are formed. The protrusions 124 are configured such that radiation reflected from the surface 123 of the individually controllable element 121 is reflected with a different phase from the radiation reflected from the protrusion 124. Accordingly, a phase-shifting mask is formed on each individually controllable element 121, patterning the corresponding portion of the beam of radiation.

Although specific reference can be made in this text to the use of lithographic apparatus in the manufacture of a specific device (e.g., an integrated circuit or a flat panel display), it should be understood that the lithographic apparatus described herein can have other applications. Applications include, but are not limited to, the manufacture of integrated circuits, integrated optical systems, guidance and detection patterns for magnetic domain memories, flat-panel displays, liquid-crystal displays (LCDs), thin-film magnetic heads, micro-electromechanical devices (MEMS), light emitting diode (LEDs), etc. Also, for instance in a flat panel display, the present apparatus can be used to assist in the creation of a variety of layers, e.g. a thin film transistor layer and/or a color filter layer.

Although specific reference can have been made above to the use of embodiments of the invention in the context of optical lithography, it will be appreciated that the invention can be used in other applications, for example imprint lithography, where the context allows, and is not limited to optical lithography. In imprint lithography a topography in a patterning device defines the pattern created on a substrate. The topography of the patterning device can be pressed into a layer of resist supplied to the substrate whereupon the resist is cured by applying electromagnetic radiation, heat, pressure or a combination thereof. The patterning device is moved out of the resist leaving a pattern in it after the resist is cured.

While specific embodiments of the invention have been described above, it will be appreciated that the invention can be practiced otherwise than as described. For example, the invention can take the form of a computer program containing one or more sequences of machine-readable instructions describing a method as disclosed above, or a data storage medium (e.g. semiconductor memory, magnetic or optical disk) having such a computer program stored therein.

### Conclusion

While various embodiments of the present invention have been described above, it should be understood that they have been presented by way of example only, and not limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the following claims and their equivalents.

It is to be appreciated that the Detailed Description section, and not the Summary and Abstract sections, is intended to be used to interpret the claims. The Summary and Abstract sections can set forth one or more, but not all exemplary embodiments of the present invention as contemplated by the inventor(s), and thus, are not intended to limit the present invention and the appended claims in any way.
The following are the claims of the parent application as filed and are included as part of the description of the present application.
1. A lithographic apparatus, comprising:
   at least one array of individually controllable elements that expose a pattern on a substrate, which is configured to perform one or more exposures of a first type and one or more exposures of a second type,
   wherein, for an exposure of the first type, a beam of radiation is modulated by the at least one array of individually controllable elements and projected onto the substrate, such that a repeating pattern is projected onto the substrate, and
   wherein, for an exposure of the second type, a beam of radiation is modulated by the at least one array of individually controllable elements and projected onto the substrate, such that the size of a portion of the exposure on the substrate corresponding to an individually controllable element is larger for an exposure of the second type than for an exposure of the first type.
2. The lithographic apparatus of claim 1, further comprising:
   first and second projection systems,
   wherein a first one of the at least one array of individually controllable elements and the first projection system are used to perform exposures of the first type, and
   wherein a second one of the at least one array of individually controllable elements and the second projection system are used to perform exposures of the second type.
3. The lithographic apparatus of claim 1, further comprising:
   a projection system;
   wherein a first one of the at least one array of individually controllable elements is used to perform exposures of the first type;
   wherein a second one of the at least one array of individually controllable elements is used to perform exposures of the second type; and
   the projection system is used for exposures of the first and second type to project a beam of radiation modulated by the first or second array of individually controllable elements, respectively, onto the substrate.
4. The lithographic apparatus of claim 3, wherein a size of the individually controllable elements of the first one of the at least one array of individually controllable elements is smaller than a size of the individually controllable elements of the second one of the at least one array of individually controllable elements.
5. The lithographic apparatus of claim 3 or 4, wherein:
   the projection system is configured such that its magnification can be changed, wherein the magnification of the projection system is different for an exposure of the first type from an exposure of the second type.
6. The lithographic apparatus of claim 1, further comprising:
   a projection system that is used to for exposures of the first and the second type to project the modulated beam radiation onto the substrate, wherein the projection system is configured such that its magnification is changed between an exposure of the first type and an exposure of the second type.
7. The lithographic apparatus of any one of the preceding claims, wherein the repeating pattern exposed on the substrate by an exposure of the first type comprises at least one of a plurality of lines, a checkerboard pattern, a plurality of circles, or a repeating unit of a device to be formed on the substrate.
8. The lithographic apparatus of any one of the preceding claims, wherein the at least one array of individually controllable elements used to perform the exposure of the first type comprises:
   a memory that is programmed to set the at least one array of individually controllable elements in order to generate the repeating pattern.
9. The lithographic apparatus of any one of claims 1 to 7, wherein the at least one array of individually controllable elements used to perform the exposure of the first type comprises:
   a memory that contains the settings necessary to set the at least one array of individually controllable elements in order to generate any one of a plurality of repeating patterns; and
   a controller that selects settings from the memory in order to set the at least one array of individually controllable elements in order to generate a desired repeating pattern.
10. The lithographic apparatus of any one of claims 1 to 7, wherein the at least one array of individually controllable elements used to perform an exposure of the first type is configured to receive settings corresponding to a repeating unit of a pattern to be exposed on the substrate and is configured to use the settings to set a plurality of areas of the at least one array of individually controllable elements, such that the repeating unit of the pattern is exposed on the substrate at a plurality of locations during the exposure.
11. The lithographic apparatus of any one of claims 1 to 7, wherein:
   the at least one array of individually controllable elements used to perform an exposure of the first type is configured to receive a control signal indicating that the repeating pattern is to be provided and, in response, to set the individually controllable elements to states necessary to modulate the beam of radiation according to the repeating pattern; and
   the at least one array of individually controllable elements comprises dedicated circuits configured to direct the control signal to a portion of the individually controllable elements in order to set them to requisite states.
12. A device manufacturing method for exposing a pattern on a substrate using a combination of one or more exposures of a first type and one or more exposures of a second type, comprising:
   for an exposure of the first type, modulating a beam of radiation using a first array of individually controllable elements and projecting the modulated beam onto the substrate, such that a repeating pattern is exposed on the substrate; and
   for an exposure of the second type, modulating a beam of radiation using a second array of individually controllable elements and projecting the modulated beam onto the substrate, such that the size of a portion of the exposure on the substrate corresponding to an individually controllable element is larger for an exposure of the second type than for an exposure of the first type.
13. A lithographic apparatus, comprising:
   a support that supports a patterning device, the patterning device modulating a beam of radiation to form a first modulated beam of radiation;
   an array of individually controllable elements that modulate the first modulated beam of radiation to form a second modulated beam of radiation; and
   a projection system that projects the second modulated beam of radiation onto a substrate.
14. The lithographic apparatus of claim 13, wherein:
   a size of a portion of the beam of radiation projected onto the substrate corresponding to a minimum feature size of the pattern provided by the patterning device supported by the support is smaller than a size of a portion of the beam of radiation projected onto the substrate corresponding to one of the individually controllable elements of the array of individually controllable elements.
15. The lithographic apparatus of claim 13 or 14, wherein the patterning device supported by the support imparts a repeating pattern to a cross-section of the beam of radiation.
16. The lithographic apparatus of claim 15, wherein the repeating pattern exposed on the substrate by the first modulated beam is at least one of a plurality of lines, a checkerboard pattern, a plurality of circles, or a repeating unit corresponding of a device to be formed on the substrate.
17. The lithographic apparatus of any one of claims 13 to 16, wherein the patterning device is an array of individually controllable elements that impart a repeating pattern to a cross-section of the beam of radiation.
18. The lithographic apparatus of claim 17, wherein the array of individually controllable elements comprises:
   a memory that contains settings necessary to set the array of individually controllable elements in order to generate the repeating pattern.
19. The lithographic apparatus of claim 17, wherein the array of individually controllable elements comprises:
   a memory that contains settings necessary to set the array of individually controllable elements in order to generate any one of a plurality of repeating patterns; and
   a controller that selects the settings from the memory in order to set the array of individually controllable elements in order to generate a desired repeating pattern.
20. The lithographic apparatus of claim 17, wherein:
   the array of individually controllable elements is configured to receive settings corresponding to a repeating unit of a pattern to be imparted to the cross-section of the beam of radiation and to use the settings to set a plurality of areas of the array of individually controllable elements, such that the repeating unit of the pattern is imparted to the beam of radiation at a plurality of locations within the cross-section of the beam of radiation.
21. The lithographic apparatus of claim 17, wherein:
   the array of individually controllable elements receive a control signal indicating that the repeating pattern is to be provided and, in response, to set the individually controllable elements to states necessary to modulate the beam of radiation according to the desired repeating pattern; and
   the array of individually controllable elements comprises dedicated circuits configured to direct the control signal to a portion of the individually controllable elements in order to set them to the requisite states.
22. The lithographic apparatus of any one of claims 13 to 16, wherein the patterning device is a mask comprising a repeating pattern.
23. The lithographic apparatus of claim 22, wherein:
   the support comprises a rotary actuator that rotates the mask about an axis perpendicular to a surface of the mask.
24. A device manufacturing method, comprising:
   using a patterning device to modulate a beam of radiation to form a first modulated beam of radiation;
   using an array of individually controllable elements to modulate the first modulated beam of radiation to form a second modulated beam of radiation; and
   projecting the second modulated beam of radiation onto a substrate.
25. A patterning device, comprising:
   an array of individually controllable elements that modulate a beam of radiation according to a repeating pattern;
   wherein the array is configured to receive a control signal indicating that the repeating pattern is to be provided and, in response, to set the individually controllable elements to states necessary to modulate the beam of radiation according to the repeating pattern.
26. The patterning device of claim 25, wherein the array of individually controllable elements comprises:
   a memory that contains the settings necessary to set the array of individually controllable elements in order to generate the repeating pattern.
27. The patterning device of claim 25, wherein the array of individually controllable elements comprises:
   a memory that contains the settings necessary to set the array of individually controllable elements in order to generate any one of a plurality of repeating patterns; and
   a controller that selects, in response to the control signal, the settings from the memory in order to set the array of individually controllable elements in order to generate a desired repeating pattern.
28. The patterning device of claim 25, wherein the array of individually controllable elements is constructed to receive settings corresponding to a repeating unit of a pattern to be exposed on the substrate and to use the settings to set a plurality of areas of the array of individually controllable elements such that the repeating unit of the pattern is exposed on the substrate at a plurality of locations during the exposure.
29. The patterning device of claim 25, wherein the array of individually controllable elements comprises:
   dedicated circuits that direct the control signal received by the array of individually controllable elements to a portion of the individually controllable elements in order to set them to the states.
30. A device manufacturing method, comprising:
   receiving a control signal at an array of individually controllable elements;
   indicating with the control signal that the array of individually controllable elements is to be set to modulate a beam of radiation according to a repeating pattern; and
   modulating the beam of radiation using the array of individually controllable elements.
31. A lithographic apparatus, comprising:
   an array of individually controllable elements that modulate a beam of radiation, the individually controllable elements comprising patterning surfaces that impart a pattern to a portion of the modulated beam of radiation corresponding to the individually controllable elements; and
   a projection system that projects the modulated beam of radiation onto a substrate.
32. The lithographic apparatus of claim 31, wherein the pattern imparted to the corresponding portion of the beam of radiation by each of the patterning surfaces is substantially the same.
33. The lithographic apparatus of claim 31 or 32, wherein:
   the individually controllable elements are grouped into a plurality of areas; and
   the patterning surfaces of the individually controllable elements of each of the areas are configured such that if the individually controllable elements of two or more of the areas are set to the same states, the patterns imparted to the corresponding portions of the beam of radiation by the patterning surfaces are the same.
34. The lithographic apparatus of any one of claims 31 to 33, wherein the pattern imparted to a portion of a beam of radiation by the patterning surfaces comprises a plurality of lines, a checkerboard pattern, a plurality of circles, or a combination of two or more of these.
35. The lithographic apparatus of any one of claims 31 to 34, wherein:
   the individually controllable elements each comprise a reflector and an associated actuator constructed to move the reflector between two or more positions; and
   the patterning surface comprises regions of relatively higher and regions of relatively lower reflectivity formed on the reflector.
36. The lithographic apparatus of claim 35, wherein at least one of the regions of relatively higher reflectivity and the regions of relatively lower reflectivity are formed on the reflector by at least one of treating a portion of the surface of the reflector in order to alter its surface texture, selective deposition of material on the surface of the reflector, and selective removal of material from the surface of the reflector.
37. The lithographic apparatus of any one of claims 31 to 34, wherein:
   the individually controllable elements each comprise a reflector and an associated actuator constructed to move the reflector between two or more positions; and
   the patterning surface comprises a non-planar shape imported to the surface of the reflector.
38. A patterning device, comprising:
   array of individually controllable elements that modulate a beam of radiation, the individually controllable elements include patterning surfaces that impart a given pattern to a portion of the modulated beam of radiation corresponding to the individually controllable element.
39. A device manufacturing method, comprising:
   modulating a beam of radiation using an array of individually controllable elements;
   using patterning surfaces of the individually controllable elements to impart a given pattern to a portion of the modulated beam of radiation corresponding to the individually controllable element; and
   projecting the modulated beam of radiation onto a substrate.

## Claims

1. A lithographic apparatus, comprising:
a support that supports a patterning device, the patterning device modulating a beam of radiation to form a first modulated beam of radiation;
an array of individually controllable elements that modulate the first modulated beam of radiation to form a second modulated beam of radiation; and
a projection system that projects the second modulated beam of radiation onto a substrate.

2. The lithographic apparatus of claim 1, wherein:
a size of a portion of the beam of radiation projected onto the substrate corresponding to a minimum feature size of the pattern provided by the patterning device supported by the support is smaller than a size of a portion of the beam of radiation projected onto the substrate corresponding to one of the individually controllable elements of the array of individually controllable elements.

3. The lithographic apparatus of claim 1 or 2, wherein the patterning device supported by the support imparts a repeating pattern to a cross-section of the beam of radiation.

4. The lithographic apparatus of claim 3, wherein the repeating pattern exposed on the substrate by the first modulated beam is at least one of a plurality of lines, a checkerboard pattern, a plurality of circles, or a repeating unit corresponding of a device to be formed on the substrate.

5. The lithographic apparatus of any one of claims 1 to 4, wherein the patterning device is an array of individually controllable elements that impart a repeating pattern to a cross-section of the beam of radiation.

6. The lithographic apparatus of claim 5, wherein the array of individually controllable elements comprises:
a memory that contains settings necessary to set the array of individually controllable elements in order to generate the repeating pattern.

7. The lithographic apparatus of claim 5, wherein the array of individually controllable elements comprises:
a memory that contains settings necessary to set the array of individually controllable elements in order to generate any one of a plurality of repeating patterns; and
a controller that selects the settings from the memory in order to set the array of individually controllable elements in order to generate a desired repeating pattern.

8. The lithographic apparatus of claim 5 wherein:
the array of individually controllable elements is configured to receive settings corresponding to a repeating unit of a pattern to be imparted to the cross-section of the beam of radiation and to use the settings to set a plurality of areas of the array of individually controllable elements, such that the repeating unit of the pattern is imparted to the beam of radiation at a plurality of locations within the cross-section of the beam of radiation.

9. The lithographic apparatus of claim 5, wherein:
the array of individually controllable elements receive a control signal indicating that the repeating pattern is to be provided and, in response, to set the individually controllable elements to states necessary to modulate the beam of radiation according to the desired repeating pattern; and
the array of individually controllable elements comprises dedicated circuits configured to direct the control signal to a portion of the individually controllable elements in order to set them to the requisite states.

10. The lithographic apparatus of any one of claims 1 to 4, wherein the patterning device is a mask comprising a repeating pattern.

11. The lithographic apparatus of claim 10, wherein:
the support comprises a rotary actuator that rotates the mask about an axis perpendicular to a surface of the mask.

12. A device manufacturing method, comprising:
using a patterning device to modulate a beam of radiation to form a first modulated beam of radiation;
using an array of individually controllable elements to modulate the first modulated beam of radiation to form a second modulated beam of radiation; and
projecting the second modulated beam of radiation onto a substrate.
